# EUROPEAN PATENT APPLICATION

(11) **EP 4 443 235 A2**
(43) Date of publication of application: **09.10.2024**
(21) Application number: 24164620.7
(22) Date of filing: 19.03.2024
(51) Int. Cl.: G03F 1/24, G03F 1/48, G03F 1/58

(54) **REFLECTIVE MASK BLANK, AND MANUFACTURING METHOD OF REFLECTIVE MASK**

(30) Priority: 04.04.2023 JP 2023060853
(71) Applicant: SHIN-ETSU CHEMICAL CO., LTD., Tokyo (JP)
(72) Inventor: INAZUKI, Yukio, Joetsu-shi (JP); KOSAKA, Takuro, Joetsu-shi (JP); OGOSE, Taiga, Joetsu-shi (JP); MIMURA, Shohei, Joetsu-shi (JP)
(74) Representative: Mewburn Ellis LLP

(57) **Abstract**

In a reflective mask blank including a substrate, a multilayer reflection film, a protection film, an absorber film and a hard mask film, the protection film is composed of a material containing ruthenium (Ru), the absorber film consists of a first layer and a second layer, or a first layer, a second layer and a third layer, the first layer has a composition containing tantalum (Ta) and being free of nitrogen (N), the second layer has a composition containing tantalum (Ta) and nitrogen (N), the third layer has a composition containing tantalum (Ta), nitrogen (N) and oxygen (O), and the hard mask film is composed of a material containing chromium (Cr).

## Description

### TECHNICAL FIELD

The present invention relates to a reflective mask blank which is a material for a reflective mask used in manufacturing semiconductor devices such as LSIs, and a manufacturing method of the reflective mask from the reflective mask blank.

### BACKGROUND

In a manufacturing process of a semiconductor device, a photolithography technique in which a circuit pattern formed on a transfer mask is transferred onto a semiconductor substrate (a semiconductor wafer) through a reduction projection optical system with irradiating exposure light to the transfer mask is repeatedly used. Conventionally, a mainstream wavelength of the exposure light is 193 nm by argon fluoride (ArF) excimer laser light. A pattern with dimensions smaller than exposure wavelength has finally been formed by adopting a process called multi-patterning in which exposure processes and processing processes are combined multiple times.

However, since it is necessary to form a further fine pattern under continuous miniaturization of device patterns, an extreme ultraviolet lithography technique using, as exposure light, extreme ultraviolet (here after refers to as "EUV") light having a shorter wavelength than the wavelength of ArF excimer laser light has been used. The EUV light is light having a wavelength of about 0.2 to 100 nm, in particular, light having a wavelength of around 13.5 nm. The EUV light has a very low transparency to a substance and cannot be utilized for a conventional transmissive projection optical system or a mask, thus, a reflection type optical elemental device is applied. Therefore, a reflective mask is also used as a mask for the pattern transfer.

In the reflective mask, a multilayer reflection film that reflects EUV light is formed on a substrate, and further an absorber film formed in a pattern that absorbs EUV light is formed on the multilayer reflection film. On the other hand, a material (including also a state in which a resist layer is formed) before patterning the absorber film is called a reflective mask blank, and is used as a material for the reflective mask. The reflective mask blank generally has a basic structure including a low thermal expansion substrate, a multilayer reflection film that is formed on one surface of two main surface of the substrate and reflects EUV light, and an absorber film that is formed thereon and absorbs EUV light.

As the multilayer reflection film, a multilayer reflection film which is ensured a necessary reflectance for EUV light by alternately laminating molybdenum (Mo) layers and silicon (Si) layers is commonly used. On the other hand, tantalum (Ta) which has a relatively large extinction coefficient with respect to EUV light is used for the absorber film (Patent Document 1: JP-A 2002-246299).

Further, as a protection film for protecting the multilayer reflection film, a ruthenium (Ru) film is formed on the multilayer reflection film, as disclosed in JP-A 2002-122981 (Patent Document 2). Besides, as an etching mask for forming a pattern to the absorber film, a hard mask film containing chromium (Cr) is formed on the absorber film in some cases. On the other hand, a conductive film is formed on the other main surface of the substrate. As the conductive film, a metal nitride film is proposed for electrostatically chucking, and a film containing chromium (Cr) or tantalum (Ta) is exemplified.

### Citation List

Patent Document 1: JP-A 2002-246299
Patent Document 2: JP-A 2002-122981

### SUMMARY OF THE INVENTION

The protection film is required to have function for protecting the multilayer reflection film. In particular, function for protecting a multilayer reflection film so as not to expose the multilayer reflection film to etching gases and cleaning liquids in processing a pattern of an absorber film, and function for suppressing decrease of reflectance due to repeated exposure in exposing using a reflective mask are exemplified.

In the manufacturing process of a reflective mask using a reflective mask blank as a material, when an absorber film is dry etched to form a pattern of an absorber film, a certain degree of over-etching is usually performed to control a pattern shape. By performing the over-etching, the protection film is exposed to etching, and is damaged. When the absorber film is composed of a material containing tantalum (Ta), a gas containing chlorine and being free of oxygen is preferably used as an etching gas. Therefore, the protection film is required to have resistance to dry etching using a gas containing chlorine and being free of oxygen.

Further, when a hard mask pattern which is obtained by forming a pattern of a hard mask film composed of a material containing chromium (Cr) is used as an etching mask in forming a pattern to the absorber film, after forming the pattern of the absorber film, usually, the pattern of the hard mask film is removed by dry etching using a gas containing chlorine and oxygen. The protection film is also exposed to the dry etching using a gas containing chlorine and oxygen at that time. Therefore, resistance to dry etching using a gas containing chlorine and oxygen is also required for the protection film.

Furthermore, to remove residues of a resist used in manufacturing the reflective mask and to remove contamination generated in repeated use of the reflective mask, cleaning using a sulfuric acid-hydrogen peroxide mixture (SPM) is performed. Therefore, the protection film is also required to have resistance to a sulfuric acid-hydrogen peroxide mixture (SPM).

If the protection film is damaged in etching in manufacturing the reflective mask, and changes in film quality and thickness are caused, problems such as loss of the function for protecting the multilayer reflection film are occurred in the protection film. Therefore, with respect to the protection film containing ruthenium (Ru), a protection film added with an additive element such as niobium (Nb) has been proposed to enhance the function for protecting the multilayer reflection film by improving the resistance to dry etching.

However, even when resistance to dry etching is enhanced by adding an additive element such as niobium (Nb) to the protection film containing ruthenium (Ru), the protection film will be thinned when the protection film is exposed to a gas containing chlorine and being free of oxygen in dry etching to the absorber film composed of a material containing tantalum (Ta). Further, the protection film will be also thinned when the protection film is exposed to a gas containing chlorine and oxygen in removing the pattern of the hard mask film. Furthermore, the protection film will be also thinned in cleaning using a sulfuric acid-hydrogen peroxide mixture (SPM).

As described above, it is difficult to avoid chemical damages to the protection film, and the protection film will be thinned by physical damages. Thus, it is necessary to control the functions of the protection film for protecting the multilayer reflection film to deterioration of the functions caused by decrease in thickness.

The present invention has been made to solve the above problems, and an object of the present invention is to provide, as a reflective mask blank in which an absorber film composed of a material containing tantalum (Ta) is formed on a protection film composed of a material containing ruthenium (Ru), a reflective mask blank including an absorber film that can reduce damage of the protection film caused by over-etching of the absorber film composed of a material containing tantalum (Ta) using a gas containing chlorine and being free of oxygen, and can control decrease of thickness of the protection film caused by dry etching using a gas containing chlorine and oxygen, or cleaning using a sulfuric acid-hydrogen peroxide mixture (SPM). Another object of the present invention is to provide a method for manufacturing a reflective mask using the reflective mask blank.

The inventors have made earnestly studies to solve the above problems. As a result, the inventors found, with respect to a reflective mask blank in which an absorber film composed of a material containing tantalum (Ta) is formed on a protection film composed of a material containing ruthenium (Ru), the absorber film having a structure including, from a substrate side, a first layer having a composition containing tantalum (Ta) and being free of nitrogen (N), and a second layer having a composition containing tantalum (Ta) and nitrogen (N). Further, the inventors found that the reflective mask blank having the structure can reduce damage of the protection film caused by over-etching of the absorber film composed of a material containing tantalum (Ta) using a gas containing chlorine and being free of oxygen, and can control decrease of thickness of the protection film caused by dry etching using a gas containing chlorine and oxygen, or cleaning using a sulfuric acid-hydrogen peroxide mixture (SPM).

In one aspect, the invention provides a reflective mask blank including a substrate, a multilayer reflection film that is formed on one main surface of the substrate and reflects exposure light, a protection film that is formed on and in contact with the multilayer reflection film, an absorber film that is formed on and in contact with the protection film and absorbs the exposure light, and a hard mask film that is formed on and in contact with the absorber film and acts as an etching mask in dry etching of the absorber film, the reflective mask blank being a material for a reflective mask that is used in EUV lithography utilizing EUV light as the exposure light wherein,
the protection film is composed of a material containing ruthenium (Ru), and has a thickness of not less than 2 nm and not more than 5 nm,
the absorber film is composed of a material containing tantalum (Ta), and consists of, from the substrate side, a first layer and a second layer, or a first layer, a second layer and a third layer,
the first layer has a composition containing tantalum (Ta) and being free of nitrogen (N), and has a thickness of not less than 0.5 nm and not more than 2 nm,
the second layer has a composition containing tantalum (Ta) and nitrogen (N), and having a nitrogen (N) content of not less than 10 at%, and an oxygen (O) content of not more than 5 at%,
the first layer and the second layer have a total thickness of not less than 50 nm and not more than 80 nm,
the third layer has a composition containing tantalum (Ta), nitrogen (N) and oxygen (O), and having an oxygen (O) content of not less than 30 at% and not more than 70 at%, and has a thickness of not more than 20 nm, and
the hard mask film is composed of a material containing chromium (Cr), and has a thickness of not less than 5 nm and not more than 20 nm.

Preferably, the composition of the first layer further contains oxygen (O).

Preferably, the composition of the first layer has an oxygen (O) content of not less than 5 at%.

Preferably, the composition of the second layer has a tantalum (Ta) content of not less than 55 at% and not more than 70 at%, and a nitrogen (N) content of not less than 30 at% and not more than 45 at%.

Preferably, the material containing ruthenium (Ru) is simple substance of ruthenium (Ru), or an alloy consisting of ruthenium (Ru) and niobium (Nb).

Preferably, the alloy consisting of ruthenium (Ru) and niobium (Nb) has a niobium (Nb) content of not more than 30 at% on average for the whole of the protection film.

In another aspect, the invention provides a method for manufacturing a reflective mask, including the steps of:
(A) preparing the reflective mask blank of claim 1,
(B) forming a resist pattern on the hard mask film,
(C) forming a pattern of the hard mask film by dry etching the hard mask film with using a gas containing chlorine and oxygen and utilizing the resist pattern as an etching mask,
(D) forming patterns of the first layer and the second layer in the absorber film by dry etching the first layer and the second layer in the absorber film with using a gas containing chlorine and being free of oxygen and utilizing the pattern of the hard mask film as an etching mask,
(E) after the step (C) or (D), removing the resist pattern, and
(F) removing the pattern of the hard mask film by dry etching using a gas containing chlorine and oxygen.

Preferably, in the step (D), the dry etching is performed so as to expose the protection film.

Preferably, in the step (D), the dry etching is performed so as to remain a part of the absorber film without exposing the protection film, and
in the step (F), the dry etching is performed so as to expose the protection film.

Preferably, the method further includes
(G) after the step (F), a step including a treatment of contacting the exposed absorber film with a sulfuric acid-hydrogen peroxide mixture (SPM).

Preferably, the method further includes
(G) after the step (F), a step including a treatment of contacting the exposed absorber film with a sulfuric acid-hydrogen peroxide mixture (SPM), wherein
in the steps (D) and (F), the dry etching is performed so as to remain a part of the absorber film without exposing the protection film, and
in the step (G), the dry etching is performed so as to expose the protection film.

Preferably, the absorber film consists of, from the substrate side, a first layer, a second layer and a third layer, and
the method further includes the step of:
(C-1) after the step (C) and before the step (D), forming a pattern of the third layer in the absorber film by dry etching the third layer in the absorber film with using a fluorine-based gas and utilizing the pattern of the hard mask film.

### ADVANTAGEOUS EFFECTS

According to the invention, the inventive reflective mask blank can reduce damage of a protection film caused by over-etching of an absorber film composed of a material containing tantalum (Ta) using a gas containing chlorine and being free of oxygen. Further, the inventive reflective mask blank can control decrease of thickness of the protection film caused by dry etching using a gas containing chlorine and oxygen, or cleaning using a sulfuric acid-hydrogen peroxide mixture (SPM).

### BRIEF DESCRIPTION OF THE DRAWINGS

FIG. 1 is a cross-sectional view illustrating an example of a reflective mask blank of the invention.
FIG. 2 is a cross-sectional view illustrating another example of a reflective mask blank of the invention.
FIG. 3 is a schematic diagram of an etching apparatus used in Experimental Examples and Comparative Experimental Examples.

### FURTHER EXPLANATIONS; OPTIONS AND PREFERENCES

A reflective mask blank of the invention includes a substrate, a multilayer reflection film that is formed on one main surface (front-side surface) of the substrate) and reflects exposure light, a protection film that is formed on the multilayer reflection film, an absorber film that is formed on the protection film and absorbs the exposure light, and a hard mask film that is formed on the absorber film. The reflective mask blank of the invention is suitable for a material for a reflective mask used in EUV lithography utilizing EUV light as exposure light. A wavelength of EUV light used in EUV lithography utilizing EUV light as exposure light is 13 to 14 nm, normally about 13.5 nm. A reflective mask blank and a reflective mask utilizing EUV light as exposure light are also called an EUV mask blank and an EUV mask, respectively.

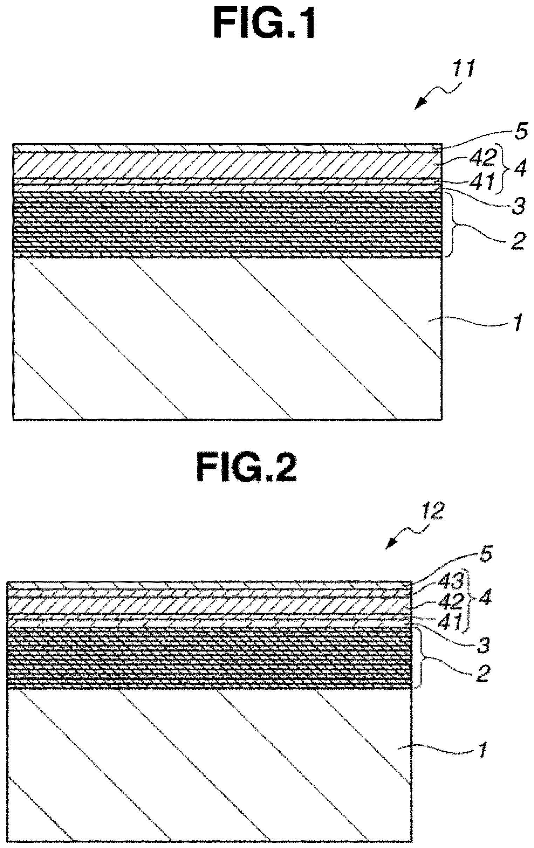

FIG. 1 is a cross-sectional view illustrating an example of a reflective mask blank of the invention. This reflective mask blank 11 includes a substrate 1, and, on the substrate 1, a multilayer reflection film 2 that is formed in contact with the substrate 1, a protection film 3 that is formed in contact with the multilayer reflection film 2, an absorber film 4 that is formed in contact with the protection film 3, and a hard mask film 5 that is formed in contact with the absorber film 4. In this case, the absorber film 4 has a structure consisting of two layers of, from the substrate 1 side, a first layer 41 and a second layer 42.

FIG. 2 is a cross-sectional view illustrating another example of a reflective mask blank of the invention. This reflective mask blank 12 includes a substrate 1, and, on the substrate 1, a multilayer reflection film 2 that is formed in contact with the substrate 1, a protection film 3 that is formed in contact with the multilayer reflection film 2, an absorber film 4 that is formed in contact with the protection film 3, and a hard mask film 5 that is formed in contact with the absorber film 4. In this case, the absorber film 4 has a structure consisting of three layers of, from the substrate 1 side, a first layer 41, a second layer 42 and a third layer 43.

For EUV light exposure, the substrate preferably has low thermal expansion property. For example, the substrate is composed of a material having a coefficient of thermal expansion preferably within ±2×10⁻⁸/°C, more preferably within ±5×10⁻⁹/°C. As such a material, for example, a titania-doped quartz glass (SiO₂-TiO₂-based glass) can be exemplified. Further, a substrate having a sufficiently flatted surface is preferably used. The main surface of the substrate has a surface roughness, as an RMS value, of preferably not more than 0.5 nm, more preferably not more than 0.2 nm. Such a surface roughness can be obtained by polishing the substrate or other methods. As dimensions of the substrate, the main surface of the substrate preferably has a 152 mm-square, and the substrate preferably has a 6.35 mm-thick. A substrate having the dimensions is so-called a 6025 substrate (a substrate having dimensions of the main surface of a 6 inches-square and 0.25 inches-thick).

The multilayer reflection film is a film that reflects exposure light, in the reflective mask. The multilayer reflection film is preferably formed in contact with one main surface of the substrate, however, may be formed via another film such as an underlayer film on the one main surface of the substrate. The multilayer reflection film has a periodically laminated structure in which high refractive index layers having a comparatively high refractive index with respect to exposure light and low refractive index layers having a comparatively low refractive index with respect to the exposure light are alternately laminated.

The high refractive index layer is preferably composed of a material containing silicon (Si). The high refractive index layer may contain at least one additive element selected from the group consisting of oxygen (O), nitrogen (N), carbon (C), boron (B) and hydrogen (H). Further, the high refractive index layer may be configured by a multilayer including a layer containing the additive element and a layer not containing the additive element. The high refractive index layer has a thickness of preferably not less than 3.5 nm, more preferably not less than 4 nm, and preferably not more than 4.9 nm, more preferably not more than 4.4 nm.

The low refractive index layer is preferably composed of a material containing molybdenum (Mo). The low refractive index layer may contain at least one additive element selected from the group consisting of oxygen (O), nitrogen (N), carbon (C), boron (B) and hydrogen (H). Further, the low refractive index layer may be configured by a multilayer including a layer containing the additive element and a layer not containing the additive element. The low refractive index layer has a thickness of preferably not less than 2.1 nm, more preferably not less than 2.6 nm, and preferably not more than 3.5 nm, more preferably not more than 3 nm.

A laminated structure constituting the periodically laminated structure may include the high refractive index layer and the low refractive index layer, and may include at least one high refractive index layer and at least one low refractive index layer. The laminated structure includes at least two layers and may configured by, for example, one high refractive index layer and one low refractive index layer. Further, the laminated structure may include at least two high refractive index layers that have different compositions (for example, different ratios in composition, or different compositions with or without an additive element) from each other, and may include at least two low refractive index layers that have different compositions (for example, different ratios in composition, or different compositions with or without an additive element) from each other. In this case, the laminated structure includes at least three layers and may include four or five or more layers, however, preferably not more than eight layers. The periodically laminated structure has cycles of the laminated structure of preferably not less than 30 cycles, and preferably not more than 50 cycles, more preferably not more than 40 cycles.

The multilayer reflection film having the periodically laminated structure has a thickness of preferably not less than 200 nm, more preferably not less than 270 nm, and preferably not more than 400 nm, more preferably not more than 290 nm.

Examples of methods for forming the multilayer reflection film include a sputtering method in which, to perform sputtering, power is supplied to a target, and plasma of an atmospheric gas is formed (an atmospheric gas is ionized) by the supplied power, and an ion beam sputtering method in which a target is irradiated with ion beam. The sputtering methods include a DC sputtering method in which a DC voltage is applied to a target, and an RF sputtering method in which a high frequency voltage is applied to a target. The sputtering method is a film forming method that utilizes sputtering phenomenon by gas ions generated by applying a voltage to a target with feeding a sputtering gas into a chamber to ionize the gas. Particularly, a magnetron sputtering method has an advantage in productivity. The power may be applied to the target by a DC system or an RF system. The DC system includes also a pulse sputtering in which a negative bias applied to the target is inverted for a short time to prevent charge-up of the target.

The multilayer reflection film may be formed by, for example, a sputtering method using a sputtering apparatus to which a plurality of targets can be attached. In particular, the multilayer reflection film may be formed with using, as targets, targets appropriately selected from the group consisting of a molybdenum (Mo) target for forming a molybdenum (Mo)-containing layer, a silicon (Si) target for forming a silicon (Si)-containing layer, and other targets, and with using, as a sputtering gas, a rare gas such as helium (He) gas, argon (Ar) gas, krypton (Kr) gas and xenon (Xe) gas.

Further, in the case that the sputtering is reactive sputtering using a reactive gas, for example, a nitrogen-containing gas such as nitrogen (N₂) gas to form a nitrogen (N)-containing film, an oxygen-containing gas such as oxygen (O₂) gas to form an oxygen (O)-containing film, a nitrogen oxide gas such as nitrous oxide (N₂O) gas, nitrogen monoxide (NO) gas and nitrogen dioxide (NO₂) gas to form a nitrogen (N) and oxygen (O)-containing film, a carbon oxide gas such as carbon monoxide (CO) gas and carbon dioxide (CO₂) gas to form a carbon (C) and oxygen (O)-containing film, a hydrogen-containing gas such as hydrogen (H₂) gas to form a hydrogen (H)-containing film, or a hydrocarbon gas such as methane (CH₄) gas to form a carbon (C) and hydrogen (H)-containing film may be used with the rare gas.

Moreover, a molybdenum (Mo) target added with boron (B) (a molybdenum boride (MoB) target), or a silicon (Si) target added with boron (B) (a silicon boride (SiB) target) may be used to form a boron (B)-containing layer.

The protection film is a film for protecting the multilayer reflection film. The protection film is formed in contact with the multilayer reflection film. The protection film is composed of a material containing ruthenium (Ru). Examples of the materials containing ruthenium (Ru) include simple substance of ruthenium (Ru), and an alloy consisting of ruthenium (Ru) and other metal or metalloid different from ruthenium (Ru). Examples of the other metal or metalloid different from ruthenium (Ru) include niobium (Nb), zirconium (Zr), titanium (Ti), chromium (Cr), silicon (Si) and others. Among the materials containing ruthenium (Ru), simple substance of ruthenium (Ru), or an alloy consisting of ruthenium (Ru) and niobium (Nb) is particularly preferred. A content of the other metal or metalloid different from ruthenium (Ru) in the protection film is preferably not more than 30 at%, more preferably not more than 20 at% on average for the whole of the protection film. A lower limit of the content of the other metal or metalloid different from ruthenium (Ru) in the protection film is preferably not less than 5 at%, more preferably not less than 10 at% on average for the whole of the protection film, however, not limited particular thereto.

The protection film may have a single layer structure or a multilayer structure combining multiple layers having different compositions. Further, each layer constituting the single layer or the multiple layers may have a compositional graded structure in which composition continuously varies along the thickness direction. Particularly, in the protection film, either or both of the side close to the multilayer reflection film (the layer close to the multilayer reflection film in the case of the multilayer structure), and the side remotest from the multilayer reflection film (the layer remotest from the multilayer reflection film in the case of the multilayer structure) may consist of ruthenium (Ru).

In the case that the protection film has a multilayer structure or a compositional graded structure, the other metal or metalloid different from ruthenium (Ru) preferably has a content that increases from the multilayer reflection film side to the side remote from the multilayer reflection film in a part of or the whole of the protection film in the thickness direction. Particularly, in the case that niobium (Nb) is contained as the other metal or metalloid different from ruthenium (Ru), niobium (Nb) is effective to improve resistance to dry etching using a gas containing chlorine and oxygen. Therefore, niobium (Nb) preferably has a content that increases from the multilayer reflection film side to the side remote from the multilayer reflection film in a part of or the whole of the protection film in the thickness direction.

The protection film has a thickness of preferably not less than 2 nm, more preferably not less than 3 nm, and preferably not more than 5 nm, more preferably not more than 4 nm.

The protection film can be formed by sputtering using, as a target, a ruthenium (Ru) target, and an optional target of the other metal or metalloid different from ruthenium (Ru), in particular, a niobium (Nb) target, a zirconium (Zr) target, a titanium (Ti) target, a chromium (Cr) target, or a silicon (Si) target, and using, as a sputtering gas, a rare gas such as helium (He) gas, argon (Ar) gas, krypton (Kr) gas and xenon (Xe) gas. The sputtering is preferably magnetron sputtering.

In the reflective mask, the absorber film is a film that absorbs exposure light and reduces reflectance. The absorber film is formed in contact with the protection film. The absorber film is a film that reduces reflectance of the exposure light with absorbing EUV light which is the exposure light. In the reflective mask, a transfer pattern is formed by a difference in reflectance between a portion where an absorber film is formed and a portion where an absorber film is not formed.

The absorber film is composed of a material that can absorb EUV light, and can be processed to a pattern, and a material containing tantalum (Ta). The material containing tantalum (Ta) may contain oxygen (O), nitrogen (N), carbon (C), boron (B) or other elements. Examples of the materials of the absorber film include, for example, a material containing tantalum (Ta). In particular, examples of the materials include simple substance of Ta, and a tantalum (Ta) compound such as TaO, TaN, TaON, TaC, TaCO, TaCN, TaCON, TaB, TaOB, TaNB, TaONB, TaCB, TaCOB, TaCNB and TaCONB.

Particularly, a material containing tantalum (Ta) and nitrogen (N) is preferable. In dry etching using a gas containing chlorine and being free of oxygen, since both etching selectivity to a protection film composed of a material containing ruthenium (Ru), and etching selectivity to a hard mask film composed of a material containing chromium (Cr) are high, the material imparts good processability in pattern forming of the absorber film. On the other hand, a material containing tantalum (Ta) and being free of nitrogen (N) is hard to be etched by dry etching using a gas containing chlorine and oxygen compared with a material containing tantalum (Ta) and nitrogen (N).

The absorber film preferably has a microcrystalline structure or an amorphous structure. The absorber film may contain at least one element selected from the group consisting of hydrogen (H), boron (B), carbon (C), silicon (Si), molybdenum (Mo), zirconium (Zr), chromium (Cr), germanium (Ge) and aluminum (Al), particularly, either or both of carbon (C) and boron (B), as long as the total content of these elements is not more than 20 at%.

The absorber film may consist of two layers which is, from the substrate side, a first layer and a second layer. In the case of the absorber film having a two-layer structure, the first layer preferably has a composition containing tantalum (Ta) and being free of nitrogen (N), and the second layer preferably has a composition containing tantalum (Ta) and nitrogen (N).

The first layer preferably contains oxygen (O). In the case that the first layer contains oxygen (O), although it has high resistance to dry etching using a gas containing chlorine and oxygen, it is advantageous that even if a small amount of the absorber film remains in areas other than the pattern of the absorber film on the protection film, it can be removed by cleaning using a sulfuric acid-hydrogen peroxide mixture (SPM). In the case that the first layer contains oxygen (O), the first layer has a content of oxygen (O) of preferably not less than 5 at%, more preferably not less than 20 at%, even more preferably not less than 50 at%. The content of oxygen (O) preferably has an upper limit of not more than 71.4 at%, however, not limited particular thereto.

The first layer has a thickness of preferably not more than 2 nm, and preferably not less than 0.5 nm, more preferably not less than 1 nm. When the first layer is too thick, the absorber film may remain on the protection film in areas other than the pattern of the absorber film in forming the pattern of the absorber film, decreasing reflectance for the reflective mask.

Preferably, the second layer is easily etched by dry etching using a gas containing chlorine and being free of oxygen. Therefore, the second layer has a nitrogen (N) content of preferably not less than 10 at%, more preferably not less than 15 at%, even more preferably not less than 30 at%. The content of nitrogen (N) has an upper limit of preferably not more than 60 at%, more preferably not more than 45 at%. Further, the second layer preferably has an oxygen (O) content of not more than 5 at%, and more preferably, the second layer is free of oxygen (O). On the other hand, the second layer has a tantalum (Ta) content of preferably not less than 40 at%, more preferably not less than 55 at%, and preferably not more than 90 at%, more preferably not more than 70 at%.

The first layer and the second layer have a total thickness (the sum of the thicknesses of the first layer and the second layer) of preferably not less than 50 nm, more preferably not less than 55 nm, and preferably not more than 80 nm, more preferably not more than 70 nm. The first layer and the second layer can be etched by dry etching using a gas containing chlorine and being free of oxygen.

The absorber film may have a two-layer structure, however, in the absorber film, when the part remotest from the protection film contains oxygen, a reflectance at an inspection wavelength for defect inspection performed in processing for a mask is reduced. Therefore, a third layer may be provided as a layer remotest from the protection film in the absorber film, and the absorber film may consist of three layers which is, from the substrate side, a first layer, a second layer and a third layer. In this case, the third layer preferably has a composition containing tantalum (Ta), nitrogen (N) and oxygen (O).

The third layer has an oxygen (O) content of preferably not less than 30 at%, more preferably not less than 50 at%, and preferably not more than 70 at%. The third layer has a tantalum (Ta) content of preferably not less than 30 at%, more preferably not less than 40 at%, and preferably not more than 70 at%, more preferably not more than 60 at%. On the other hand, the third layer has a nitrogen (N) content of preferably not more than 50 at%, more preferably not more than 40 at%. The content of nitrogen (N) has a lower limit of preferably not less than 5 at%, more preferably not less than 10 at%, however, not limited particular thereto.

The third layer has a thickness of preferably not more than 20 nm, more preferably not more than 10 nm, even more preferably not more than 5 nm. The thickness of the third layer has a lower limit of preferably not less than 1 nm, more preferably not less than 3 nm, however, not limited particular thereto. The third layer can be etched by dry etching using a fluorine-based gas (fluorine-based dry etching).

The absorber film has a sheet resistance of preferably not more than 1×10⁶ Ω/square, more preferably not more than 1×10⁵ Ω/square. The absorber film has a surface roughness Sq of preferably not more than 0.8 nm, more preferably not more than 0.6 nm.

The absorber film (each layer constituting the absorber film) can be formed by sputtering, and the sputtering is preferably magnetron sputtering. In particular, the absorber film may be formed by sputtering using a target such as a tantalum (Ta) target, a tantalum (Ta) compound target (a target containing tantalum (Ta), and at least one element selected from the group consisting of oxygen (O), nitrogen (N), carbon (C), boron (B) and other elements), and using, as a sputtering gas, a rare gas such as helium (He) gas, neon (Ne) gas, argon (Ar) gas, krypton (Kr) gas and xenon (Xe) gas, or by reactive sputtering using, as the sputtering gas, a reactive gas such as an oxygen-containing gas, a nitrogen-containing gas and a carbon-containing gas, in particular, oxygen (O₂) gas, nitrogen (N₂) gas, a nitrogen oxide (N₂O, NO, NO₂) gas, and a carbon oxide (CO, CO₂) gas, with the rare gas.

Among the layers constituting the absorber film, the third layer may be a layer that is formed by natural oxidation under an atmosphere containing oxygen (O₂) gas such as under the air at the part remotest from the protection film in the second layer. Further, the third layer may be formed by heat treatment of the part remotest from the protection film in the formed second layer under an atmosphere containing oxygen (O₂) gas such as under the air.

A hard mask film (an etching mask film for the absorber film) having different etching characteristics from that of the absorber film can be provided on the absorber film at the side remotest from the substrate. The hard mask film acts as an etching mask in dry etching of the absorber film. The hard mask film is formed in contact with the absorber film.

Examples of materials for the hard mask film include a material containing chromium (Cr). The material containing chromium (Cr) has different etching characteristics in processing the absorber film composed of a material containing tantalum (Ta). The hard mask film composed of the material containing chromium (Cr) act as an etching mask in dry etching the absorber film, thus, the hard mask film is suitable. Therefore, the hard mask film is preferably free of tantalum (Ta).

Examples of the materials containing chromium (Cr) include CrO, CrN, CrON, CrC, CrOC, CoNC, and CrONC. The hard mask film composed of a material containing chromium (Cr) is normally removed by dry etching using a gas containing chlorine and oxygen in manufacturing process of a reflective mask. Therefore, the hard mask film preferably has a high etching rate in such dry etching, CrONC is preferable as the material containing chromium (Cr) in this regard. The hard mask film composed of a material containing chromium (Cr) has a chromium (Cr) content of preferably not more than 60 at%, more preferably not more than 50 at%, and preferably not less than 30 at%, more preferably not less than 40 at%.

After the pattern of the absorber film is formed, the hard mask film may be remained in the reflective mask, for example, as a reflectance reducing film for reducing reflectance at a wavelength of light used in inspection such as pattern inspection, or may be removed to be absent on the reflective mask. Particularly, the hard mask film composed of a material containing chromium (Cr) is preferable in the case that the absorber film is composed of a material containing tantalum (Ta) and free of chromium (Cr).

The hard mask film may be formed on the second layer of the absorber film. In the case that the absorber film includes the third layer having function that reduces a reflectance at a wavelength of light used in inspection such as pattern inspection, the hard mask film may be formed on the third layer of the absorber film. The hard mask film can be formed by, for example a magnetron sputtering method. When the hard mask film is too thin, the hard mask film may not act as an etching mask, and when the hard mask film is too thick, processing properties may be deteriorated. Thus, the hard mask film has a thickness of preferably not less than 5 nm, and preferably not more than 20 nm, more preferably not more than 10 nm, however, not limited particular thereto.

The hard mask film can be formed by sputtering, and the sputtering is preferably magnetron sputtering. In particular, the hard mask film may be formed by sputtering using a target such as a chromium (Cr) target, a chromium compound target (a target containing Cr, and at least one element selected from the group consisting of oxygen (O), nitrogen (N), carbon (C), boron (B) and other elements), and using, as a sputtering gas, a rare gas such as helium (He) gas, argon (Ar) gas, krypton (Kr) gas and xenon (Xe) gas, or by reactive sputtering using, as the sputtering gas, a reactive gas such as an oxygen-containing gas, a nitrogen-containing gas and a carbon-containing gas, in particular, oxygen (O₂) gas, nitrogen (N₂) gas, a nitrogen oxide (N₂O, NO, NO₂) gas, and a carbon oxide (CO, CO₂) gas, with the rare gas.

A conductive film used for electrostatic chucking to attach a reflective mask to an exposure apparatus may be formed on the other main surface (back-side surface) which is opposite across the substrate to the one main surface, preferably in contact with the other main surface.

The conductive film preferably has a sheet resistance of not more than 100 Ω/square, and a material for the conductive film is not limited. Examples of materials of the conductive film include, for example, a material containing tantalum (Ta) or chromium (Cr). The material containing tantalum (Ta) or chromium (Cr) may contain oxygen (O), nitrogen (N), carbon (C), boron (B) or other elements. Examples of the materials containing tantalum (Ta) include, for example, simple substance of Ta, and a tantalum (Ta) compound such as TaO, TaN, TaON, TaC, TaCN, TaCO, TaCON, TaB, TaOB, TaNB, TaONB, TaCB, TaCNB, TaCOB and TaCONB. Examples of the materials containing chromium (Cr) include, for example, simple substance of Cr, and a chromium (Cr) compound such as CrO, CrN, CrON, CrC, CrCN, CrCO, CrCON, CrB, CrOB, CrNB, CrONB, CrCB, CrCNB, CrCOB and CrCONB.

The conductive film has a thickness of normally about 20 to 300 nm, however, not limited particularly thereto as long as the thickness is enough to act for electrostatic chucking use. The conductive film is preferably formed so as to have a thickness at which film stresses between the conductive film, and the multilayer reflection film, the protection film and a pattern of the absorber film are balanced after obtaining the reflective mask, i.e., after forming the pattern of the absorber film. The conductive film may be formed before forming the multilayer reflection film, or after forming all the films on the substrate at the multilayer reflection film side. After forming a part of the films on the substrate at the multilayer reflection film side, the conductive film may be formed, and then the remainder of the films at the multilayer reflection film side may be formed on the substrate. The conductive film can be formed by, for example, a magnetron sputtering method.

The reflective mask blank may include a resist film formed on the side remotest from the substrate. The resist film is preferably an electron beam (EB) resist.

From the reflective mask blank, for example, a reflective mask including a substrate, a multilayer reflection film that is formed on one main surface of the substrate, a protection film that is formed in contact with the multilayer reflection film, and an absorber pattern (a pattern of an absorber film) that is formed by patterning the absorber film) and is formed in contact with the protection film can be manufactured. In the reflective mask, a transfer pattern is formed by a difference in reflectance between a portion where an absorber film is formed and a portion where an absorber film is not formed.

From the hard mask film composed of a material containing chromium (Cr), a pattern of the hard mask film (a hard mask pattern) can be formed by dry etching using a gas containing chlorine and oxygen. From the absorber film composed of a material containing tantalum (Ta), a pattern of the absorber film (an absorber pattern) can be formed by dry etching using a gas containing chlorine and being free of oxygen. The pattern of the hard mask film acts as an etching mask on this dry etching. After forming the absorber pattern, the hard mask pattern can be removed by dry etching using a gas containing chlorine and oxygen. After removing the hard mask pattern, the absorber film remaining in areas other than the absorber pattern, and/or the exposed protection film may be subjected to a treatment of contacting with a sulfuric acid-hydrogen peroxide mixture (SPM), for example, a cleaning by a sulfuric acid-hydrogen peroxide mixture (SPM).

In particular, the reflective mask of the invention can be manufactured by a method including the steps of:
(A) preparing the reflective mask blank,
(B) forming a resist pattern on the hard mask film,
(C) forming a pattern of the hard mask film by dry etching the hard mask film with using a gas containing chlorine and oxygen and utilizing the resist pattern as an etching mask,
(D) forming patterns of the first layer and the second layer in the absorber film by dry etching the first layer and the second layer in the absorber film with using a gas containing chlorine and being free of oxygen and utilizing the pattern of the hard mask film as an etching mask,
(E) after the step (C) or (D), removing the resist pattern, and
(F) removing the pattern of the hard mask film by dry etching using a gas containing chlorine and oxygen.

In the step (D), the dry etching may be performed so as to expose the protection film. In the step (D), the dry etching may be performed so as to remain a part of the absorber film, preferably a part of or the whole of the first layer without exposing the protection film, and in the step (F), the dry etching may be performed so as to expose the protection film.

The manufacturing method for the reflective mask of the invention may further include the step of:
(G) after the step (F), a step including a treatment of contacting the exposed absorber film with a sulfuric acid-hydrogen peroxide mixture (SPM).

When the manufacturing method for the reflective mask of the invention includes the step (G), in the steps (D) and (F), the dry etching may be performed so as to remain a part of the absorber film without exposing the protection film, and in the step (G), the dry etching may be performed so as to expose the protection film.

When the absorber film consists of, from the substrate side, a first layer, a second layer and a third layer, preferably, the method further includes the step of:
(C-1) after the step (C) and before the step (D), forming a pattern of the third layer in the absorber film by dry etching the third layer in the absorber film with using a fluorine-based gas and utilizing the pattern of the hard mask film.

### EXAMPLES

Examples of the invention are given below by way of illustration and not by way of limitation.

### Experimental Example 1

As a protection film (thickness: 3.9 nm), a RuNb film (Ru:Nb=82:18 (atomic ratio)) was formed on a main surface of a low thermal expansion substrate (SiO₂-TiO₂-based glass substrate) having dimensions of 152 mm-square and 6.35 mm-thick. A multi-cathode sputtering apparatus in which a Ru target and a Nb target were attached was used for forming the RuNb film, the low thermal expansion substrate was placed into a chamber, and the RuNb film was formed by DC pulse magnetron sputtering while rotating the substrate. The RuNb film was formed with feeding Ar gas (flow rate: 10 sccm) into the chamber at a pressure in the chamber of 0.016 Pa, and applying an electric power of 400W to the Ru target and an electric power of 200W to the Nb target.

Next, as an absorber film (thickness: 60.0 nm), a TaO layer (Ta:O=70:30 (atomic ratio)) having a thickness of 1.0 nm and a TaN layer (Ta:N=57:43 (atomic ratio)) having a thickness of 59.0 nm were formed in order on the RuNb film to obtain a substrate with films for evaluation. Another sputtering apparatus in which a Ta target was attached was used for forming the TaO layer and the TaN layer, the substrate on which the RuNb film was formed was placed into a chamber, the TaO layer and the TaN layer were formed by DC pulse magnetron sputtering while rotating the substrate. The TaO layer was formed with feeding Ar gas (flow rate: 40 sccm) and O₂ gas (flow rate: 30 sccm) into the chamber at a pressure in the chamber of 0.14 Pa, and applying an electric power of 1,000W to the Ta target. The TaN layer was formed with feeding Ar gas (flow rate: 70 sccm) and N₂ gas (flow rate: 120 sccm) into the chamber at a pressure in the chamber of 0.48 Pa, and applying an electric power of 1,800W to the Ta target.

The obtained substrate in which the protection film and the absorber film were formed was taken out from the chamber to the atmosphere. As a result, it was confirmed that a TaON layer (Ta:O:N=40:30:30 (atomic ratio)) having a thickness of 1.0 nm was formed by natural oxidation at the surface portion of the TaN layer remotest from the protection film.

### Experimental Example 2

A substrate with films for evaluation was obtained in the same manner as in Experimental Example 1 except that a TaO layer (Ta:O=80:20 (atomic ratio)) having a thickness of 1.5 nm was formed, and the TaN layer having a thickness of 58.5 nm was formed. The TaO layer was formed with feeding Ar gas (flow rate: 40 sccm) and O₂ gas (flow rate: 30 sccm) into the chamber at a pressure in the chamber of 0.14 Pa, and applying an electric power of 1,800W to the Ta target.

The obtained substrate in which the protection film and the absorber film were formed was taken out from the chamber to the atmosphere. As a result, it was confirmed that a TaON layer (Ta:O:N=40:30:30 (atomic ratio)) having a thickness of 1.0 nm was formed by natural oxidation at the surface portion of the TaN layer remotest from the protection film.

### Experimental Example 3

A substrate with films for evaluation was obtained in the same manner as in Experimental Example 2 except that a Ta layer having a thickness of 1.5 nm was formed instead of the TaO layer. The Ta layer was formed with feeding Ar gas (flow rate: 18 sccm) into the chamber at a pressure in the chamber of 0.07 Pa, and applying an electric power of 500W to the Ta target.

The obtained substrate in which the protection film and the absorber film were formed was taken out from the chamber to the atmosphere. As a result, it was confirmed that a TaON layer (Ta:O:N=40:30:30 (atomic ratio)) having a thickness of 1.0 nm was formed by natural oxidation at the surface portion of the TaN layer remotest from the protection film.

### Comparative Experimental Example 1

A substrate with films for evaluation was obtained in the same manner as in Experimental Example 1 except that the TaN layer having a thickness of 60.0 nm was formed without forming the TaO layer.

The obtained substrate in which the protection film and the absorber film were formed was taken out from the chamber to the atmosphere. As a result, it was confirmed that a TaON layer (Ta:O:N=40:30:30 (atomic ratio)) having a thickness of 1.0 nm was formed by natural oxidation at the surface portion of the TaN layer remotest from the protection film.

### Experimental Example 4

As a protection film (thickness: 3.9 nm), a Ru film was formed on a main surface of a low thermal expansion substrate (SiO₂-TiO₂-based glass substrate) having dimensions of 152 mm-square and 6.35 mm-thick. A sputtering apparatus in which a Ru target was attached was used for forming the Ru film, the low thermal expansion substrate was placed into a chamber, and the Ru film was formed by DC pulse magnetron sputtering while rotating the substrate. The Ru film was formed with feeding Ar gas (flow rate: 10 sccm) into the chamber at a pressure in the chamber of 0.016 Pa, and applying an electric power of 400W to the Ru target.

Next, as an absorber film (thickness: 60.0 nm), a TaO layer (Ta:O=60:40 (atomic ratio)) having a thickness of 2.0 nm and a TaN layer (Ta:N=57:43 (atomic ratio)) having a thickness of 58.0 nm were formed in order on the Ru film to obtain a substrate with films for evaluation. Another sputtering apparatus in which a Ta target was attached was used for forming the TaO layer and the TaN layer, the substrate on which the Ru film was formed was placed into a chamber, the TaO layer and the TaN layer were formed by DC pulse magnetron sputtering while rotating the substrate. The TaO layer was formed with feeding Ar gas (flow rate: 15 sccm) and O₂ gas (flow rate: 40 sccm) into the chamber at a pressure in the chamber of 0.13 Pa, and applying an electric power of 500W to the Ta target. The TaN layer was formed with feeding Ar gas (flow rate: 70 sccm) and N₂ gas (flow rate: 120 sccm) into the chamber at a pressure in the chamber of 0.48 Pa, and applying an electric power of 1,800W to the Ta target.

The obtained substrate in which the protection film and the absorber film were formed was taken out from the chamber to the atmosphere. As a result, it was confirmed that a TaON layer (Ta:O:N=40:30:30 (atomic ratio)) having a thickness of 1.0 nm was formed by natural oxidation at the surface portion of the TaN layer remotest from the protection film.

### Comparative Experimental Example 2

A substrate with films for evaluation was obtained in the same manner as in Experimental Example 4 except that the TaN layer having a thickness of 60.0 nm was formed without forming the TaO layer.

The obtained substrate in which the protection film and the absorber film were formed was taken out from the chamber to the atmosphere. As a result, it was confirmed that a TaON layer (Ta:O:N=40:30:30 (atomic ratio)) having a thickness of 1.0 nm was formed by natural oxidation at the surface portion of the TaN layer remotest from the protection film.

### <Evaluation of protection film and absorber film>

Using each of the substrates with films for evaluation obtained in Experimental Examples and Comparative Experimental Examples, the following treatments (i) to (iii) were performed in order, and the thicknesses of the films remaining on the substrate were measured after each of the treatment (i), the treatment (ii) and the treatment (iii). The thickness of the films was measured by an X-ray diffractometer (SmartLab, manufactured by Rigaku Corporation). The results are shown in Table 1.

First, dry etching using a fluorine-based gas was performed to remove the TaON layer.

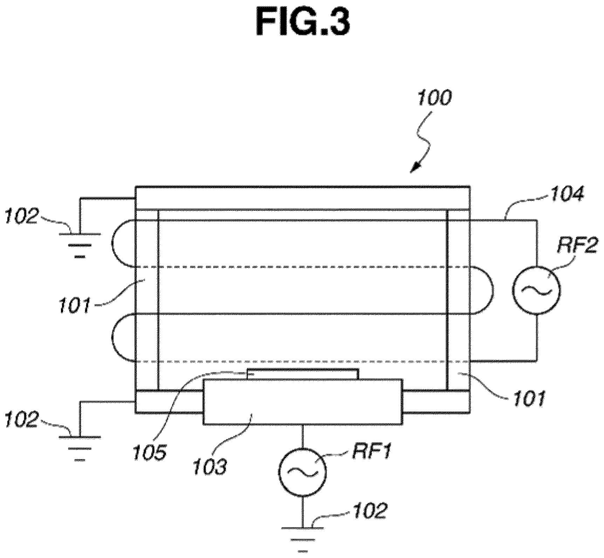

The dry etching was carried out by an etching apparatus shown in FIG. 3 under the following conditions. FIG. 3 is a schematic diagram of a dry etching apparatus (the same applied to the following dry etchings) used for the dry etching. The dry etching apparatus 100 includes a chamber 101, grounds 102, a lower electrode 103, an antenna coil 104, and high frequency power sources RF1 and RF2. In this case, a substrate to be treated (a substrates with films for evaluation) 105 is placed on the lower electrode 103.

### <Conditions for dry etching using fluorine-based gas>

RF1 (RIE: reactive ion etching): CW (continuous discharge) 54W
RF2 (ICP: Inductively coupled plasma): CW (continuous discharge) 325W
Pressure: 5 mTorr (0.67 Pa)
SF₆: 18 sccm
He: 130 sccm
Treating time: 10 seconds

### Treatment (i): dry etching using a gas containing chlorine and being free of oxygen

The dry etching was carried out by an etching apparatus shown in FIG. 3 under the following conditions. During etching, emission spectrum from plasma was measured by an optical emission spectrometer (OES) equipped in the etching apparatus, an intensity of emitted light derived from nitrogen (N) was monitored, and the point when the intensity of emitted light derived from nitrogen (N) started to decrease was automatically detected as an end point. A 20 % of the time (t) from the start of etching to the end point was added as an over-etching time to the time (t), and the time corresponding to 120% of the time (t) was set as a treating time. The treating time is shown in Table 1.

### < Etching conditions for treatment (i)>

RF1 (RIE: reactive ion etching): CW (continuous discharge) 625W
RF2 (ICP: Inductively coupled plasma): CW (continuous discharge) 300W
Pressure: 5 mTorr (0.67 Pa)
Cl₂: 150 sccm
He: 10 sccm

### Treatment (ii): dry etching using a gas containing chlorine and oxygen

The dry etching was carried out by an etching apparatus shown in FIG. 3 under the following conditions.

### < Etching conditions for treatment (ii)>

RF1 (RIE: reactive ion etching): CW (continuous discharge) 625W
RF2 (ICP: Inductively coupled plasma): CW (continuous discharge) 300W
Pressure: 5 mTorr (0.67 Pa)
Cl₂: 150 sccm
O₂: 30 sccm
He: 10 sccm
Treating time: 20 seconds

### Treatment (iii): cleaning using a sulfuric acid-hydrogen peroxide mixture (SPM)

The substrate with films for evaluation was immersed into a sulfuric acid-hydrogen peroxide mixture (SPM), which was a mixture of 90 wt% of sulfuric acid aqueous solution and 30 wt% of hydrogen peroxide solution (sulfuric acid aqueous solution:hydrogen peroxide solution=3:1 (volume ratio)) for 6 minutes at room temperature (25 °C).

**Table 1**

| T: Thickness | Protection film | | Absorber film | | | | | | | Treating time [second] | Film thickness after treatment [nm] | | |
|---|---|---|---|---|---|---|---|---|---|---|---|---|---|
| | | | Tₐₗₗ [nm] | First layer | | Second layer | | Third layer | | | | | |
| Tₐₗₗ: Total thickness | | | | TaO or Ta layer | | TaN layer | | TaON layer | | | | | |
| | Composition (atomic ratio) | T [nm] | | Composition (atomic ratio) | T [nm] | Composition (atomic ratio) | T [nm] | Composition (atomic ratio) | T [nm] | Treatment (ii) | (i) | (ii) | (iii) |
| Experimental Example 1 | RuNb (82:12) | 3.9 | 60.0 | TaO (70:30) | 1.0 | TaN (57:43) | 58.5 | TaON (40:30:30) | 1.0 | 143 | 3.8 | 3.8 | 3.1 |
| Experimental Example 2 | RuNb (82:12) | 3.9 | 60.0 | TaO (80:20) | 1.5 | TaN (57:43) | 57.5 | TaON (40:30:30) | 1.0 | 140 | 4.2 | 4.2 | 3.9 |
| Experimental Example 3 | RuNb (82:12) | 3.9 | 60.0 | Ta | 1.5 | TaN (57:43) | 57.5 | TaON (40:30:30) | 1.0 | 119 | 4.1 | 4.1 | 3.8 |
| Comparative Experimental Example 1 | RuNb (82:12) | 3.9 | 60.0 | | | TaN (57:43) | 59.0 | TaON (40:30:30) | 1.0 | 124 | 3.6 | 3.6 | 2.9 |
| Experimental Example 4 | Ru | 3.9 | 60.0 | TaO (60:40) | 2.0 | TaN (57:43) | 57.0 | TaON (40:30:30) | 1.0 | 141 | 4.0 | 4.0 | 3.7 |
| Comparative Experimental Example 2 | Ru | 3.9 | 60.0 | | | TaN (57:43) | 59.0 | TaON (40:30:30) | 1.0 | 126 | 3.6 | 0.5 | 0.3 |

The thicknesses of the protection films after the treatment (i) were decreased in the substrates with films for evaluation not including the first layer (Comparative Experimental Examples 1 and 2). On the other hand, in the substrates with films for evaluation including the first layer (Experimental Examples 1 to 4), the thicknesses of the protection films after the treatment (i) remained at almost the same thicknesses as the formed thicknesses.

The treating times of treatment (i) of the substrates with films for evaluation including the TaO layer as the first layer of the absorber film (Experimental Examples 1, 2 and 4) were long compared to those of the substrates with films for evaluation not including the first layer (Comparative Experimental Examples 1 and 2). It is considered that since nitrogen (N) diffused from the TaN layer to form a TaON layer at the interface portion between the TaO layer and the TaN layer, the detection of the end point of etching was delayed.

In the substrates with films for evaluation including the first layer (Experimental Examples 1 to 4), the decreases of the thickness by the treatment (i) were small compared to the substrates with films for evaluation not including the first layer (Comparative Experimental Examples 1 and 2). Particularly, in Experimental Examples 2 to 4, a part of the absorber film (a part of the first layer) remained after the treatment (i).

In the substrates with films for evaluation in which the protection film was the RuNb film (Experimental Examples 1 to 3 and Comparative Experimental Example 1), the thicknesses were not decreased by the treatment (ii) in Experimental Examples 1 to 3. On the contrary, in Experimental Example 1 in which the protection film (RuNb film) was exposed after treatment (i) and Comparative Experimental Example 1, the decreases of the thickness by the treatment (iii) were large compared to Experimental Examples 2 to 4 in which a part of the absorber film (a part of the first layer) remained after treatment (i).

In the substrates with films for evaluation in which the protection film was the Ru film (Experimental Example 4 and Comparative Experimental Example 2), the thickness was not decreased by the treatment (ii) in Experimental Example 4 in which a part of the absorber film (a part of the first layer) remained after treatment (i). On the contrary, in Comparative Example 2 in which the protection film (Ru film) was exposed after treatment (i), the decrease of the thickness by the treatment (ii) was remarkably large.

In the substrates with films for evaluation in which the protection film was the RuNb film, and the protection film (RuNb film) was exposed after treatment (i) (Experimental Example 1 and Comparative Experimental Example 1), the decreases of the thickness by the treatment (iii) were large compared to Comparative Experimental Example 2 in which the protection film was the Ru film, and the protection film (Ru film) was exposed after treatment (i). Even when substrates with films for evaluation include the protection film of RuNb film, the decreases of the thickness by the treatment (iii) were small in Experimental Examples 2 to 4 in which a part of the absorber film (a part of the first layer) remained after treatment (i).

## Claims

1. A reflective mask blank comprising a substrate, a multilayer reflection film that is formed on one main surface of the substrate and reflects exposure light, a protection film that is formed on and in contact with the multilayer reflection film, an absorber film that is formed on and in contact with the protection film and absorbs the exposure light, and a hard mask film that is formed on and in contact with the absorber film and acts as an etching mask in dry etching of the absorber film, the reflective mask blank being a material for a reflective mask that is used in EUV lithography utilizing EUV light as the exposure light wherein,
the protection film is composed of a material comprising ruthenium (Ru), and has a thickness of not less than 2 nm and not more than 5 nm,
the absorber film is composed of a material comprising tantalum (Ta), and consists of, from the substrate side, a first layer and a second layer, or a first layer, a second layer and a third layer,
the first layer has a composition comprising tantalum (Ta) and being free of nitrogen (N), and has a thickness of not less than 0.5 nm and not more than 2 nm,
the second layer has a composition comprising tantalum (Ta) and nitrogen (N), and having a nitrogen (N) content of not less than 10 at%, and an oxygen (O) content of not more than 5 at%,
the first layer and the second layer have a total thickness of not less than 50 nm and not more than 80 nm,
the third layer has a composition comprising tantalum (Ta), nitrogen (N) and oxygen (O), and having an oxygen (O) content of not less than 30 at% and not more than 70 at%, and has a thickness of not more than 20 nm, and
the hard mask film is composed of a material comprising chromium (Cr), and has a thickness of not less than 5 nm and not more than 20 nm.

2. The reflective mask blank of claim 1 wherein the composition of the first layer further comprises oxygen (O).

3. The reflective mask blank of claim 2 wherein the composition of the first layer has an oxygen (O) content of not less than 5 at%.

4. The reflective mask blank of any one of claims 1 to 3 wherein the composition of the second layer has a tantalum (Ta) content of not less than 55 at% and not more than 70 at%, and a nitrogen (N) content of not less than 30 at% and not more than 45 at%.

5. The reflective mask blank of any one of claims 1 to 4 wherein the material comprising ruthenium (Ru) is simple substance of ruthenium (Ru), or an alloy consisting of ruthenium (Ru) and niobium (Nb).

6. The reflective mask blank of claim 5 wherein the alloy consisting of ruthenium (Ru) and niobium (Nb) has a niobium (Nb) content of not more than 30 at% on average for the whole of the protection film.

7. A method for manufacturing a reflective mask, comprising the steps of:
(A) preparing the reflective mask blank any one of claims 1 to 6,
(B) forming a resist pattern on the hard mask film,
(C) forming a pattern of the hard mask film by dry etching the hard mask film with using a gas comprising chlorine and oxygen and utilizing the resist pattern as an etching mask,
(D) forming patterns of the first layer and the second layer in the absorber film by dry etching the first layer and the second layer in the absorber film with using a gas comprising chlorine and being free of oxygen and utilizing the pattern of the hard mask film as an etching mask,
(E) after the step (C) or (D), removing the resist pattern, and
(F) removing the pattern of the hard mask film by dry etching using a gas comprising chlorine and oxygen.

8. The method of claim 7 wherein in the step (D), the dry etching is performed so as to expose the protection film.

9. The method of claim 7 wherein
in the step (D), the dry etching is performed so as to remain a part of the absorber film without exposing the protection film, and
in the step (F), the dry etching is performed so as to expose the protection film.

10. The method of claim 8 or 9 further comprising
(G) after the step (F), a step comprising a treatment of contacting the exposed absorber film with a sulfuric acid-hydrogen peroxide mixture (SPM).

11. The method of claim 7 further comprising
(G) after the step (F), a step comprising a treatment of contacting the exposed absorber film with a sulfuric acid-hydrogen peroxide mixture (SPM), wherein
in the steps (D) and (F), the dry etching is performed so as to remain a part of the absorber film without exposing the protection film, and
in the step (G), the dry etching is performed so as to expose the protection film.

12. The method of any one of claims 7 to 11 wherein the absorber film consists of, from the substrate side, a first layer, a second layer and a third layer, and
the method further comprising the step of:
(C-1) after the step (C) and before the step (D), forming a pattern of the third layer in the absorber film by dry etching the third layer in the absorber film with using a fluorine-based gas and utilizing the pattern of the hard mask film.
